# EUROPEAN PATENT APPLICATION

(11) **EP 2 955 845 A1**
(43) Date of publication of application: **16.12.2015**
(21) Application number: 14172054.0
(22) Date of filing: 12.06.2014
(51) Int. Cl.: H03F 3/217, H03F 1/32

(54) **Switch mode power amplifier architecture comprising a polyharmonic reconstruction filter**

(71) Applicant: Alcatel Lucent, 92100 Boulogne-Billancourt (FR)
(72) Inventor: Wantiez, Eric, 91620 Nozay (FR)
(74) Representative: Camus, Olivier Jean-Claude

(57) **Abstract**

The invention relates to a switch mode power amplifier architecture (20) comprising a polyharmonic reconstruction filter (21) adapted and construed to receive, from a power amplifier (22), a transmission amplified radio frequency signal containing many harmonics. The polyharmonic reconstruction filter (21) comprises a set of filters (23) connected to a nodal point (24) at the power amplifier (22) output.

## Description

### FIELD OF THE INVENTION

The invention relates to a switch mode power amplifier architecture comprising a polyharmonic reconstruction filter. The invention may operate with signals utilized in the 3G, 4G and 5G mobile telecommunication networks or any kinds of application requiring high efficient RF transmission based on switched mode architecture.

### BACKGOUND AND RELATED ART

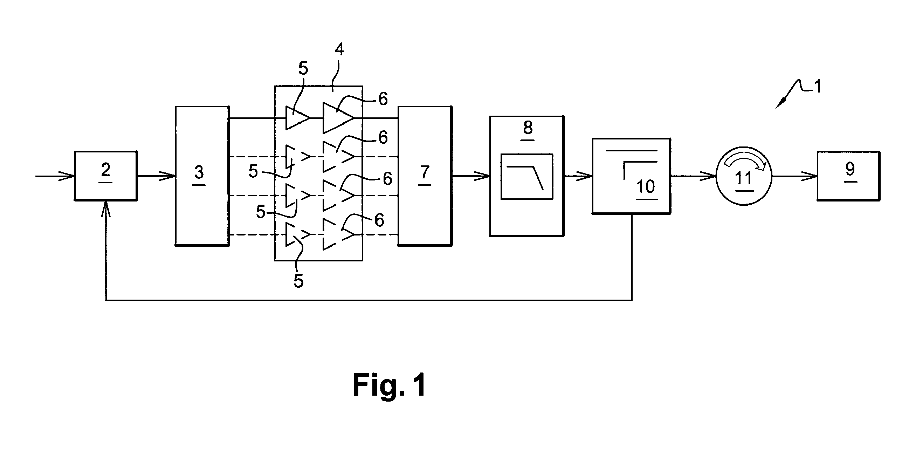

Currently, switch mode power amplifier architecture is based on binary or ternary digital transceiver(s) feeding single or multiple power amplifier(s) branch(s) in switch mode such as D, E or S class. By instance, a class-S power amplifier is a switched-mode power amplifier with several transistors acting as switches in blocked or satured state showing up to 100% ¨efficiency. A switch mode power amplifier architecture 1 consisting of the following basic building blocks, which are shown in figure 1:
- means of digital pre-compensation and/or pre-distortion 2, which aims to obtain an output signal amplified without distortion coming from following blocs,
- an high efficient and high speed encoder 3, which maps the information contained in a base band or high-frequency carrier signal into a stream of pulses of variable length & position but constant amplitude (Pulse Width Modulator, Pulse Position Modulator, Sigma Delta Modulator encoders) representing the original carrier signal at high over sampling rate,
- a switching amplifier 4, which may consist of two parts, drivers 5 and high power amplifiers 6, provides the necessary amplification by switching transistor gate of drain gate with minimum distortion (high slew rate technology),
- a RF combiner network 7, having a summing function,
- a loss-pass filter 8, which serves to reconstruct the amplified signal by suppressing high frequency harmonics, and offer low loss over the fundamental frequency band to transmit the signal to an antenna 9,
- a directional coupler 10, which is coupled with the loss-pass filter 8 output in order to pass the output signal from the loss-pass filter 8 to:
   o an isolator 11, and
   o to the means of digital pre-distortion 2, this connection allows to pick up a sample of the amplified reconstructed signal through a dedicated feedback chain. ,
- an isolator 11, which protects the transmit chain from any mismatch caused by antenne feed, provides proper matching for high efficient power transfer from the loss-pass filter 8 to the antenna 9.

It could be noted that such switch mode power amplifier architecture 1 generates multi harmonic frequencies covering a very rich harmonic spectrum (over many GHz). However, the reconstruction filter 8 is a simple loss-pass (or band pass) filter meaning that multi-harmonic frequencies are simply rejected showing high reflexion back to the transmit chain. As a consequence, this type of reconstruction filter jeopardize with power, linearity, and efficiency performances as soon as switch mode power amplifier architecture transmit chain output is not properly matched over multi harmonic frequencies.

Further, the isolator 11 is bandwidth limited (about 100MHz). Consequently, such an isolator 11 cannot help multi harmonic matching even if located before the reconstruction filter 8. Then it is not good enough as the power amplifier output match over multi harmonic frequencies (over many GHz).

The aforementioned drawbacks cause power reduction that reduces the global efficiency of the switch mode power amplifier architecture. Furthermore unmatched multiharmonic frequencies cause non expected non linearities that the pre-compensation / pre-distortion bloc 2 would try to correct. This will cause addition algorithm complexity,linearity limitation (Spectrum emission Mask / Adjacent Channel Leakage Ratio degradation) and efficiency reduction. Indeed, any digital precompensation / predistortion required amplifier power back off that reduces the capability of the global chain to meet linearity/efficiency target.

### SUMMARY OF THE INVENTION

Accordingly, the present invention is directed to a switch mode power amplifier architecture arranged and constructed to obtain an increasing of the global efficiency of the switch mode power amplifier architecture.

To achieve these advantages, and in accordance with the purpose of the invention as embodied, the present invention relates to a switch mode power amplifier architecture comprising a polyharmonic reconstruction filter adapted and construed to receive, from a power amplifier, a transmission amplified radio frequency signal containing many harmonics, said polyharmonic reconstruction filter comprising a set of filters connected to a nodal point at the power amplifier output, said set of filters comprising :
- a first filter arranged and constructed to reconstruct the fundamental frequency of the transmission amplified radio frequency signal,
- at least one second filter arranged and constructed to cancel out a specific harmonic frequency of said transmission amplified radio frequency signal, said at least one second filter being a band pass filter.

In addition to the main features aforementioned in the previous paragraph, the switch mode power amplifier architecture according to the invention may also have one or more of the additional features below, taken individually or in any technically feasible combination.

In a not limited embodiment, the first filter is a low-pass filter, a narrow band isolator or a band pass filter. Band pass filter can then merge the reconstruction filter and receive band protection in order to save cumulating insertion loss and improve global efficiency.

In a not limited embodiment, the second filter is a high pass filter or a narrow band isolator.

Thus, in a general manner the set of filters can comprises a mixing of low pass, band pass filter(s) and narrow band isolator(s).

In a not limited embodiment, the switch mode power amplifier architecture further comprises an isolator connected to the polyharmonic reconstruction filter output.

In a not limited embodiment, the switch mode power amplifier architecture further comprises a directional coupler connected to the polyharmonic reconstruction filter output and the isolator input, said directional coupler being further arranged and constructed to realize a digital pre-distortion feedback to means of pre-distortion.

In a not limited embodiment, the switch mode power amplifier architecture further comprises a diplexer, the input duplexer being connected to the isolator output.

In a not limited embodiment, the polyharmonic reconstruction filter integrates a diplexer function.

In a not limited embodiment, the switch mode power amplifier architecture further comprises an isolator wherein the isolator input is connected to the nodal point and the isolator output is connected to the first filter.

In a not limited embodiment, the first filter output is connected to a third filter input, the third filter output being connected to an antenna 34, said third filter being arranged and constructed to implement a diplexer function of transmission.

In a not limited embodiment, the third filter is a high pass filter or a band pass filter or a narrow band isolator.

In a not limited embodiment, the antenna is further connected to a fourth filter input, said fourth filter being arranged and constructed to implement a diplexer function of reception.

In a not limited embodiment, the switch mode power amplifier architecture further comprises a directional coupler located between the first filter output and the third filter input, said directional coupler being further arranged and constructed to realize a digital pre-distortion feedback to means of pre-distortion.

In a not limited embodiment, the first filter is a band pass filter and the first filter output is connected to an antenna, said first filter being further arranged and constructed to implement a diplexer function of transmission.

In a not limited embodiment, the antenna is further connected to a fourth filter input, said fourth filter being arranged and constructed to implement a diplexer function of reception.

In a not limited embodiment, the switch mode power amplifier architecture further comprising a directional coupler wherein the directional coupler output is connected to the polyharmonic reconstruction filter input, said directional coupler being further arranged and constructed to realize a digital pre-distortion feedback to means of pre-distortion.

In a not limited embodiment, the switch mode power amplifier architecture comprises three second filters,
a first second filter being an H3 harmonic filter (bandwidth shall be minimum 3 times fundamental bandwidth),
- a second second filter being an H5 harmonic filter (bandwidth shall be minimum 5 times fundamental bandwidth), and
- a third second filter being an H7 harmonic filter (bandwidth shall be minimum 7 times fundamental bandwidth).

In a not limited embodiment, the second filter arranged and constructed to cancel out a specific harmonic frequency of the transmission amplified radio frequency signal is able to cancel out a specific harmonic frequency up to H5 type.

### BRIEF DESCRIPTION OF THE DRAWINGS:

Further features and advantages of the invention will become clear upon reading the following description given by way of non-limiting indication and with reference to the accompanying drawings, in which:
- Figure 1 illustrates a switch mode power amplifier architecture according to the background and related art;
- Figure 2 illustrates, in a first none-limitative embodiment, a switch mode power amplifier architecture according to the invention,
- Figure 3 illustrates, in a second none-limitative embodiment, a switch mode power amplifier architecture according to the invention,
- Figure 4 illustrates, in a third none-limitative embodiment, a switch mode power amplifier architecture according to the invention.

For reasons of clarity, only those elements beneficial for comprehension of the invention have been shown, more specifically schematically and with no regard for scale. Furthermore, like elements illustrated in different figures are denoted by like reference numerals.

### DETAILLED DESCRIPTION:

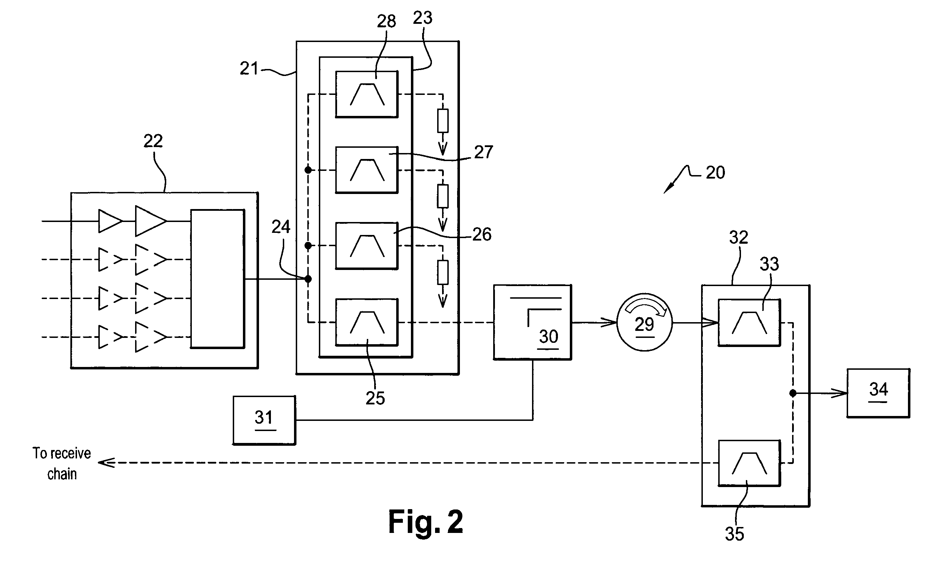

The figure 2 illustrates a first none-limitative embodiment of a switch mode power amplifier architecture 20 according to the invention. The switch mode power amplifier architecture 20 according to the invention comprises a polyharmonic reconstruction filter 21 adapted and construed to receive, from a power amplifier 22, a transmission amplified radio frequency signal containing many harmonics.

In this embodiment, the polyharmonic reconstruction filter 21 comprises a set of four filters 23 connected to a nodal point 24 at the power amplifier 22 output. More particularly, the set of four filters 23 comprises:
- a first filter 25 arranged and constructed to reconstruct the fundamental frequency of the transmission amplified radio frequency signal, the first filter 25 being a low-pass filter in the example,
- three second filters 26, 27, 28 arranged and constructed to cancel out a specific harmonic frequency of said transmission amplified radio frequency signal, each of said second filter 26, 27 and 28 being a band pass filter.

By instance, the three second filters 26, 27, 28 are formed of:
- a first second filter 26, said first second filter 26 being an H3 harmonic filter,
- a second second filter 27, said second second filter 27 being an H5 harmonic filter, and
- a third second filter 28, said third second filter being an H7 harmonic filter.

Further, the switch mode power amplifier architecture 20 comprises a directional coupler 30 connected to the polyharmonic reconstruction filter 21 output and to an isolator 29 input. The directional coupler 30 being further arranged and constructed to realize a digital pre-distortion feedback to means of pre-distortion 31. Means of pre-distortion 31 can be formed by a DPD bloc.

The isolator output is connected to a diplexer 32, which diplexer 32 comprises a third filter 33 (the third filter 33 is a band pass filter in the example), the third filter 33 input being connected to the isolator output and the third filter 33 output being connected to an antenna 34. The third filter 33 is arranged and constructed to implement a diplexer function of transmission.

It could be noted that the isolator 29 is located at the end of the transmission chain, after the polyharmonic reconstruction filter 21. The isolator mission is then to protect the radio frequency transmission chain from any misconnection, causing high voltage standing wave ratio (VSWR) and potentionally global failure of the radio frequency transmission chain.

Besides, the polyharmonic reconstruction filter 21 allows substituting narrow band to wide band isolator function for switch mode power amplifier architecture.

Moreover, the diplexer 32 comprises also a fourth filter 35. The fourth filter 35 input is connected to the antenna 34 and the output is connected to a receive chain. In the example, the fourth filter 35 is a band-pass filter.

In a general manner, the invention consists in a set of filters 23 combined with a nodal point 24 at the power amplifier output. One first filter 25 (which can be a low pass or a band pass filter) is dedicated to fundamental frequency up to the antenna 34 through the narrow band isolator 29. Some other second filters 26, 27, 28 (which are band pass filters) are dedicated to multi harmonic frequencies in order not to generate poly harmonic VSWR. If these polyharmonic filters 26, 27, 28 don't need to be low loss as this energy is wasted to 50 ohms loads, they need to show bandwidth high enough to capture the total energy. Considering the required bandwidth of the radio frequency chain (called BWf), H3 second filter 26 bandwidth needs to be three times (3xBWf) because of the band expansion. Bandwidth of H5 second filter 27 bandwidth would then be 5xBWf, and so on...

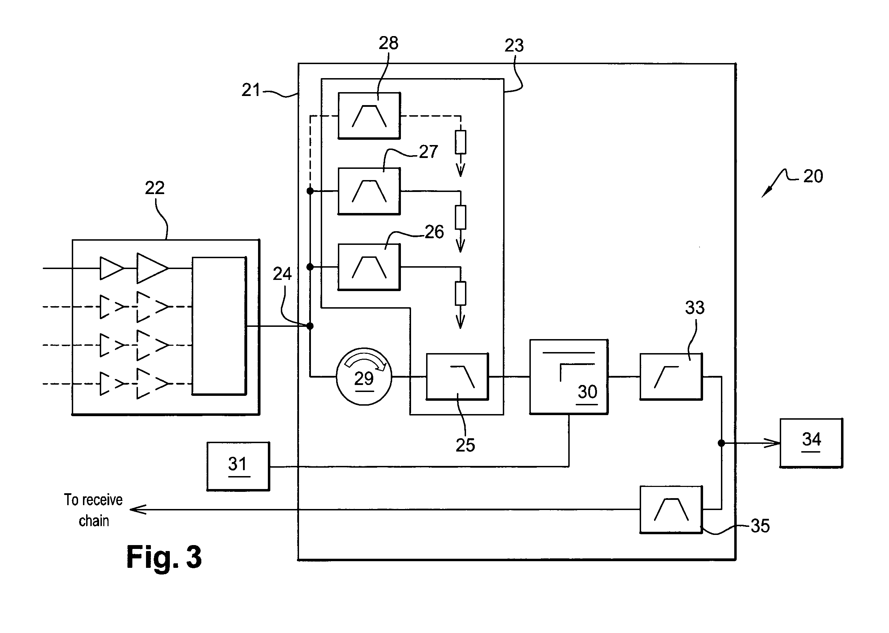

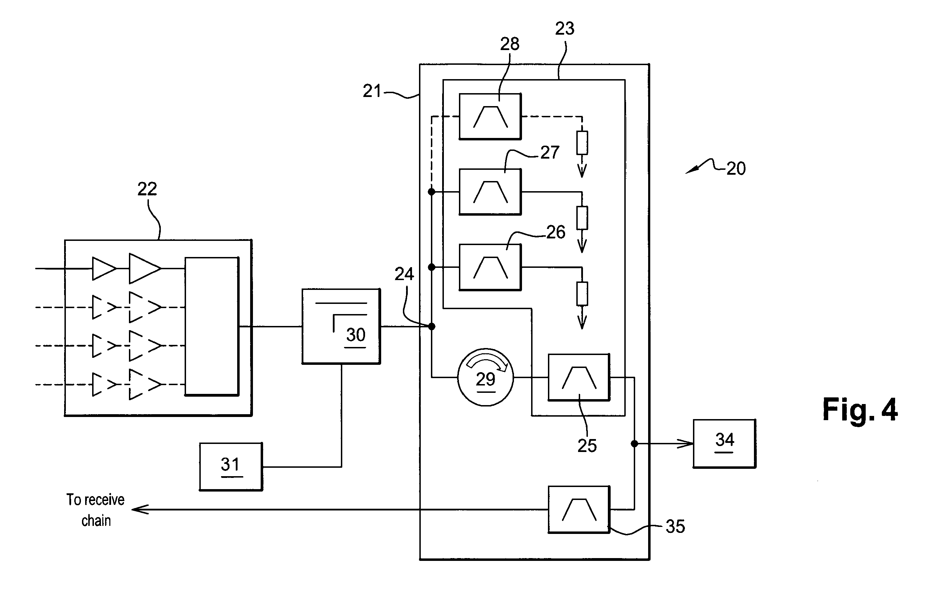

Figures 3 and 4 illustrate two switch mode power amplifier architectures 20 wherein the polyharmonic reconstruction filter 21 and the duplexer are merged in a single bloc.

According to the figure 3, the switch mode power amplifier architecture 20 comprises a polyharmonic reconstruction filter 21 adapted and constructed to receive, from the power amplifier 22, a transmission amplified radio frequency signal containing many harmonics.

In this embodiment, the polyharmonic reconstruction filter 21 comprises a set of four filters 23 connected to a nodal point 24 at the power amplifier 22 output. More particularly, the set of four filters 23 comprises:
- a first filter 25 arranged and constructed to reconstruct the fundamental frequency of the transmission amplified radio frequency signal, the first filter being a low-pass filter in this example,
- three second filters 26, 27, 28 arranged and constructed to cancel out a specific harmonic frequency of said transmission amplified radio frequency signal, each of said second filter 26, 27, 28 being a band pass filter.

By instance, the three second filters 26, 27, 28 are formed of:
- a first second filter 26, said first second filter 26 being an H3 harmonic filter,
- a second second filter 27, said second second filter 27 being an H5 harmonic filter, and
- A third second filter 28, said third second filter being an H7 harmonic filter.

In this embodiment, the isolator 29 input is connected to the nodal point 24 and the isolator output is connected to the first filter 25.

As previously indicated, in this none limited embodiment, the polyharmonic reconstruction filter 21 integrates a diplexer function. In order to realize the diplexer function of transmission, the polyharmonic reconstruction filter 21 integrates a third filter 33 (the third filter 33 is a high pass filter in this example), wherein the third filter 33 input is connected to the first filter 25 output and the third filter 33 output is connected to the antenna 34. The third filter 33 is arranged and constructed to implement a diplexer function of transmission. In this not limited embodiment, the third filter 33 is a Highpass Filter.

Further, in order to realize the diplexer function of reception, the polyharmonic reconstruction filter 21 integrates a fourth filter 35, wherein the fourth filter 35 input is connected to the antenna 34 and the fourth filter 35 output is connected to the receive chain. The fourth filter 35 is arranged and constructed to implement a diplexer function of reception. The fourth filter 35 is a band pass filter in this example.

The switch mode power amplifier architecture 20 comprises also a directional coupler 30 located between the first filter 25 output and the third filter 33 input. The directional coupler 30 is further arranged and constructed to realize a digital pre-distortion feedback to means of pre-distortion 31.

This not limited embodiment suggests another possibility of switch mode power amplifier architecture 20 for LTE (for *Long Term Evolution)* FDD (for *(Frequency Division Duplexing)* where Uplink spectrum frequencies are lower than Downlink spectrum frequency such as in band I with Downlink 2110-2170MHz, Uplink 1920-1980MHz. In this case directional coupler 30 is located between low pass 25 and high pass 33 filter in order not to damage feedback spectrum in uplink frequency range.

According to the figure 4, the switch mode power amplifier architecture 20 comprises a polyharmonic reconstruction filter 21 adapted and construed to receive, from the power amplifier 22, a transmission amplified radio frequency signal containing many harmonics.

In this embodiment, the polyharmonic reconstruction filter 21 comprises a set of four filters 23 connected to a nodal point 24 at the power amplifier 22 output. More particularly, the set of four filters 23 comprises:
- a first filter 25 arranged and constructed to reconstruct the fundamental frequency of the transmission amplified radio frequency signal, the first filter 25 being a band pass filter in this example,
- three second filters 26, 27, 28 arranged and constructed to cancel out a specific harmonic frequency of said transmission amplified radio frequency signal, each second filter 26, 27, 28 being formed by a band pass filter.

By instance, the three second filters 26, 27, 28 are formed of:
- a first second filter 26, said first second filter 26 being an H3 harmonic filter,
- a second second filter 27, said second second filter 27 being an H5 harmonic filter, and
- a third second filter 28, said third second filter being an H7 harmonic filter.

In this embodiment, the isolator 29 input is connected to the nodal point 24 and the isolator output is connected to the first filter 25.

As previously indicated, in this none limited embodiment, the polyharmonic reconstruction filter 21 integrates a diplexer function. In order to realize the diplexer function of transmission, the first filter 25 output is connected to the antenna 34 and the first filter 25 is arranged and constructed to implement the diplexer function of transmission.

Further, in order to realize the diplexer function of reception, the polyharmonic reconstruction filter 21 integrates a fourth filter 35, wherein the fourth filter 35 input is connected to the antenna 34 and the fourth filter 35 output is connected to the receive chain. The fourth filter 35 is arranged and constructed to implement a diplexer function of reception. In this example, the fourth filter 35 is formed by a band pass filter.

The switch mode power amplifier architecture 20 comprises also a directional coupler 30. In this embodiment, the directional coupler 30 input is connected to the power amplifier 22 and the directional coupler 30 output is connected to the polyharmonic reconstruction filter 21 input. The directional coupler 30 being further arranged and constructed to realize a digital predistortion feedback to means of pre-distortion 31.

This not limited embodiment, the directional coupler, required to feed the feedback chain to a DPD bloc, is kept between power amplifier output and polyharmonic filters. This proposal allows to keep high radio frequency bandwidth for feedback chain, independent of the duplixer design. In this case, polyharmonic can be integrated in the unique element to ease input & output nodal point design (matching, insertion loss and Intermodulation sensitive).

It could be noted that the switch mode power amplifier architecture 20 according to the invention uses conventional technologies. The switch mode power amplifier architecture 20 can be based on microstrip, stripline, air cavities, ceramic cavities, triple mode resonators, etc... Then design depends on application (high/low power), performances (insertion loss/rejection/matching) and integration constraints.

## Claims

1. Switch mode power amplifier architecture (20) comprising a polyharmonic reconstruction filter (21) adapted and construed to receive, from a power amplifier (22), a transmission amplified radio frequency signal containing many harmonics, said polyharmonic reconstruction filter (21) comprising a set of filters (23) connected to a nodal point (24) at the power amplifier (22) output, said set of filters (23) comprising :
- a first filter (25) arranged and constructed to reconstruct the fundamental frequency of the transmission amplified radio frequency signal,
- at least one second filter (26) arranged and constructed to cancel out a specific harmonic frequency of said transmission amplified radio frequency signal, said at least one second filter (26) being a band pass filter.

2. Switch mode power amplifier architecture (20) according to claim 1 or 2, wherein the first filter (25) is a low-pass filter, a band-pass filter or a narrow band isolator.

3. Switch mode power amplifier architecture (20) according to claim 1 or 2, wherein the second filter (26) is a high pass filter or a narrow band isolator.

4. Switch mode power amplifier architecture (20) according to claim 1, 2 or 3 further comprising isolator (29) connected to the polyharmonic reconstruction filter (21) output.

5. Switch mode power amplifier architecture (20) according to claim 4 further comprising a directional coupler (30) connected to the polyharmonic reconstruction filter (21) output and the isolator (29) input, said directional coupler (30) being further arranged and constructed to realize a digital pre-distortion feedback to means of predistortion (31).

6. Switch mode power amplifier architecture (20) according to claim 4 or 5 further comprising a diplexer (32), the input duplexer (32) being connected to the isolator (29) output.

7. Switch mode power amplifier architecture (20) according to claim 1, wherein the polyharmonic reconstruction filter (21) integrates a diplexer function.

8. Switch mode power amplifier architecture (20) according to claim 7 further comprising an isolator (29) wherein the isolator input is connected to the nodal point (24) and the isolator output is connected to the first filter (25).

9. Switch mode power amplifier architecture (20) according to claim 7 or 8 wherein the first filter (25) output is connected to a third filter (33) input, the third filter (33) output being connected to an antenna (34), said third filter (33) being arranged and constructed to implement a diplexer function of transmission.

10. Switch mode power amplifier architecture (20) according to claim 9 wherein the third filter (33) is a high-pass filter or a band-pass filter or a narrow band isolator.

11. Switch mode power amplifier architecture (20) according to claim 9 or 10 wherein the antenna (34) is further connected to a fourth filter (35) input, said fourth filter (35) being arranged and constructed to implement a diplexer function of reception.

12. Switch mode power amplifier architecture (20) according to one of the claims 9 to 11 further comprising a directional coupler (30) located between the first filter (25) output and the third filter (33) input, said directional coupler (30) being further arranged and constructed to realize a digital pre-distortion feedback to means of pre-distortion (31).

13. Switch mode power amplifier architecture (20) according to claim 8 wherein the first filter (25) is a band pass filter and the first filter (25) output is connected to an antenna (34), said first filter (25) being further arranged and constructed to implement a diplexer function of transmission.

14. Switch mode power amplifier architecture (20) according to claim 13 wherein the antenna (34) is further connected to a fourth filter (35) input, said fourth filter (35) being arranged and constructed to implement a diplexer function of reception.

15. Switch mode power amplifier architecture (20) according to claim 13 or 14 further comprising a directional coupler (30) wherein the directional coupler (30) output is connected to the polyharmonic reconstruction filter (21) input, said directional coupler (30) being further arranged and constructed to realize a digital pre-distortion feedback to means of pre-distortion (31).
